(19) Europäisches Patentamt
European Patent Office
Office européen des brevets

(11) EP 2 599 815 B1

(12) **EUROPEAN PATENT SPECIFICATION**

(45) Date of publication and mention of the grant of the patent:
**28.02.2018 Bulletin 2018/09**

(21) Application number: **11812600.2**

(22) Date of filing: **28.07.2011**

(51) Int Cl.:
***C08G 67/04*** *(2006.01)* ***C08G 59/42*** *(2006.01)*
***H01L 33/60*** *(2010.01)* ***C08G 73/02*** *(2006.01)*

(86) International application number:
**PCT/JP2011/067365**

(87) International publication number:
**WO 2012/015011 (02.02.2012 Gazette 2012/05)**

(54) **POLYCARBOXYLIC ACID CONDENSATE, THERMOSETTING RESIN COMPOSITION, SUBSTRATE FOR MOUNTING SEMICONDUCTOR ELEMENT AND PROCESS FOR PRODUCING SAME, AND SEMICONDUCTOR DEVICE**

POLYCARBOXYLSÄURE-KONDENSAT, DUROPLASTISCHE HARZZUSAMMENSETZUNG, SUBSTRAT ZUR MONTAGE EINES HALBLEITERELEMENTS UND VERFAHREN ZU SEINER HERSTELLUNG SOWIE HALBLEITERVORRICHTUNG

CONDENSAT DE POLY(ACIDE CARBOXYLIQUE), COMPOSITION DE RÉSINE THERMODURCISSABLE, SUBSTRAT POUR MONTER UN ÉLÉMENT SEMI-CONDUCTEUR ET PROCÉDÉ POUR PRODUIRE CELUI-CI, ET DISPOSITIF À SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.07.2010 US 805445**

(43) Date of publication of application:
**05.06.2013 Bulletin 2013/23**

(73) Proprietor: **Hitachi Chemical Co., Ltd.**
**Chiyoda-ku**
**Tokyo 100-6606 (JP)**

(72) Inventors:
- **KOTANI Hayato**
**Tsukuba-shi**
**Ibaraki 300-4247 (JP)**
- **URASAKI Naoyuki**
**Tsukuba-shi**
**Ibaraki 300-4247 (JP)**
- **MIZUTANI Makoto**
**Tsukuba-shi**
**Ibaraki 300-4247 (JP)**

(74) Representative: **Beckmann, Claus et al**
**Kraus & Weisert**
**Patentanwälte PartGmbB**
**Thomas-Wimmer-Ring 15**
**80539 München (DE)**

(56) References cited:
**EP-A1- 2 233 507** **WO-A1-2009/088059**
**JP-B1- 48 003 716** **US-A- 388 185**
**US-A- 3 182 073** **US-A- 5 428 082**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 599 815 B1

## Description

### Technical Field

The present invention relates to a polyvalent carboxylic acid condensate, a thermosetting resin composition, a photosemiconductor element mounting board and a method for producing it, and a photosemiconductor device.

### Background Art

Photosemiconductor devices incorporating photosemiconductor elements such as LEDs (Light Emitting Diodes) and fluorescent materials have high energy efficiency and long life spans, and are therefore used in outdoor displays, portable liquid crystal backlights, and vehicle devices, with ever increasing remand. With the advances in high luminance of LED devices, it has become a goal to prevent deterioration of photosemiconductor devices due to increased junction temperature caused by increased element heat generation or by increased direct light energy.

Patent literature 1 discloses a photosemiconductor element mounting board employing a thermosetting resin composition that comprises an epoxy resin and a curing agent such as an acid anhydride.

### Citation List

### Patent Literature

[Patent literature 1] JP 2006-140207 A

### Summary of Invention

### Technical Problem

However, when it is attempted to produce a photosemiconductor mounting board by transfer molding with a conventional thermosetting resin composition, the resin composition exudes through the gap between the cope and drag of the die during molding, tending to result in resin smudge. When resin smudge occurs during hot molding, the resin smudge spreads out to the openings (recesses) in the board serving as the photosemiconductor element-mounted region, causing interference to photosemiconductor element mounting. Even when a photosemiconductor element has been successfully mounted on an opening, the resin smudge may sometimes create problems such as connection defects during electrical connection between the photosemiconductor element and metal wiring by bonding wires. Therefore, resin smudge at the openings of a board requires addition of a resin smudge removal step in the production process for photosemiconductor element mounting boards. An example of a removal step is a method of carrying out electrolytic degreasing treatment and dip degreasing treatment steps, followed by removal of the soiling components by high-pressure water rinsing or media blasting, or with an air gun. Such a step is known as a "deflush steep". Usually a method of exposing the board to a strongly alkaline chemical solution is employed in the deflush step to remove resin smudge.

When the method described above is employed, however, the resin components elute from the non-resin-smudged sections, i.e. from the molded and cured product, often impairing the outer appearance of the product. Improvement is therefore desired in the alkali resistance of cured products formed from thermosetting resin compositions.

It is an object of the invention to provide a polyvalent carboxylic acid condensate that can yield cured products with excellent resistance to alkalis and sufficiently reduced elution of resin components when used as an epoxy resin curing agent. It is an object of the present invention, which has been accomplished in light of these circumstances, to provide a thermosetting resin composition with sufficiently excellent moldability, excellent resistance to alkalis, and sufficiently reduced elution of resin components, as well as a photosemiconductor element mounting board and method for producing the same, and a photosemiconductor device, which employ the same. WO-A-2009/088059 discloses a thermosetting epoxy moulding material containing a polyvalent carboxylic acid condensate as a curing agent.

### Solution to Problem

The present invention relates to a polyvalent carboxylic acid condensate in which a carboxyl group-containing compound is intramolecularly condensed as described in the present claims, the polyvalent carboxylic acid condensate having a constituent unit derived from the carboxyl group-containing compound which has solubility in water of no greater than 100 g/L at 30°C.

When such a polyvalent carboxylic anhydride is used as a curing agent for an epoxy resin, it is possible to form a cured product with excellent resistance to alkalis and sufficiently reduced elution of resin components.

If the polyvalent carboxylic acid condensate of the invention has a constituent unit derived from the aforementioned carboxyl group-containing compound as an end group, it will exhibit even more excellent resistance to alkalis.

The constituent unit derived from the carboxyl-containing compound is a constituent unit derived from the carboxyl-containing compound of trimellitic acid.

The polyvalent carboxylic acid condensate of the invention contains a component represented by the following general formula (1), it exhibits excellent resistance to alkalis and is suitable as a curing agent for an epoxy resin. In formula (1), $R_x$ represents a divalent organic group, multiple $R_x$ groups in the same molecule may be the same or different, and n represents an integer of 0 or greater.

[Chemical formula 1]

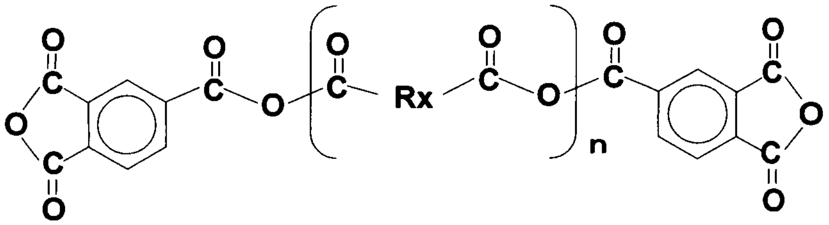

(1)

$R_x$ is a divalent group with an aliphatic hydrocarbon ring, wherein the aliphatic hydrocarbon ring is optionally substituted with a halogen atom or a linear or branched hydrocarbon group.

$R_x$ is preferably a divalent group represented by the following general formula (10). In formula (10), m represents an integer of 0-4, $R_z$ represents a halogen atom or linear or branched C1-4 hydrocarbon group, and when m is 2-4 the multiple $R_z$ groups may be the same or different and linked together to form a ring.

[Chemical formula 2]

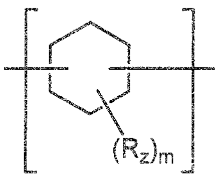

(10)

The invention relates to a thermosetting resin composition comprising (A) an epoxy resin and (B) a curing agent, wherein the (B) curing agent contains the above polyvalent carboxylic acid condensate.

The curing agent may further contain a compound represented by the following formula (2).

[Chemical formula 3]

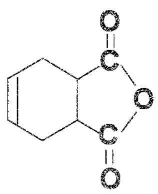

(2)

Also, the curing agent may further contain a compound represented by the following formula (3).

[Chemical formula 4]

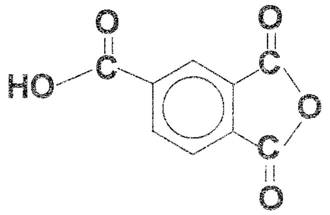 (3)

The content of the polyvalent carboxylic acid condensate in the thermosetting resin composition of the invention is preferably 10-150 parts by weight with respect to 100 parts by weight of the (A) epoxy resin.

The invention further provides a thermosetting resin composition comprising (A) an epoxy resin and (B) a curing agent, wherein the (B) curing agent contains at least one of an acid anhydride selected from the group consisting of a compound represented by the following general formula (1), a compound represented by the following formula (2) and a compound represented by the following formula (3).

[Chemical formula 5]

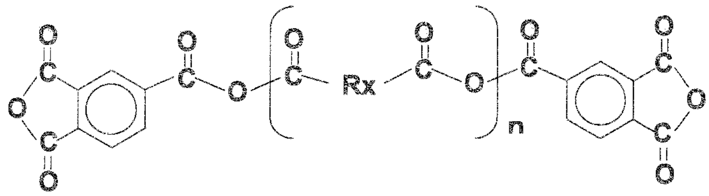 (1)

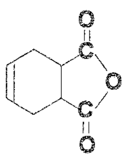 (2) 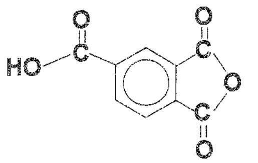 (3)

In the thermosetting resin composition of the invention, the equivalent ratio of epoxy groups in the (A) epoxy resin and acid anhydride groups in the (B) curing agent that are reactive with epoxy groups is preferably between 1:0.3 and 1:1.2.

The thermosetting resin composition of the invention preferably further comprises (D) a white pigment to increase the optical reflectance from the visible light to the near ultraviolet light range after curing.

The (D) white pigment preferably includes at least one inorganic material selected from the group consisting of alumina, magnesium oxide, antimony oxide, titanium oxide, zirconium oxide and inorganic hollow particles.

The invention further provides a photosemiconductor element mounting board having a recess composed of the bottom face and the wall faces, wherein the bottom face of the recess is the photosemiconductor element mounting section and at least parts of the wall faces of the recess are made of a cured thermosetting resin composition of the invention.

The invention still further provides a method for producing a photosemiconductor element mounting board having a recess composed of the bottom face and the wall faces, the method for producing a photosemiconductor element mounting board comprising a step of forming at least parts of the wall faces of the recess using a thermosetting resin composition of the invention.

The invention still further provides a photosemiconductor device comprising a photosemiconductor element mounting board having a recess composed of the bottom face and the wall faces, a photosemiconductor element disposed in the recess of the photosemiconductor element mounting board and a sealing resin section in which the recess is filled to seal the photosemiconductor element, wherein at least parts of the wall faces of the recess are made of a cured thermosetting resin composition of the invention.

**Advantageous Effects of Invention**

When used as a curing agent for epoxy resins, the polyvalent carboxylic acid condensate of the invention can

yield cured products with excellent resistance to alkalis and sufficiently reduced elution of resin components. According to the invention it is possible to provide a thermosetting resin composition with excellent resistance to alkalis and sufficiently excellent moldability, as well as a photosemiconductor element mounting board and method for producing the same, and a photosemiconductor device, which employ the same.

## Brief Description of Drawings

Fig. 1 is a perspective view showing an embodiment of a photosemiconductor element mounting board of the invention.
Fig. 2 is a schematic diagram showing an embodiment of a step for production of a photosemiconductor element mounting board of the invention.
Fig. 3 is a schematic diagram showing a step of removing resin smudge of the embodiment.
Fig. 4 is a perspective view showing an embodiment of the mounted state of a photosemiconductor element on a photosemiconductor element mounting board of the invention.
Fig. 5 is a schematic cross-sectional view showing an embodiment of a photosemiconductor device according to the invention.
Fig. 6 is a schematic cross-sectional view showing an embodiment of a photosemiconductor device according to the invention.
Fig. 7 is a schematic cross-sectional view showing an embodiment of a photosemiconductor device according to the invention.

## Description of Embodiments

Preferred embodiments of the invention will now be explained in detail, with reference to the accompanying drawings as necessary. Throughout the drawings, corresponding elements will be referred to by like reference numerals and will be explained only once. Unless otherwise specified, the vertical and horizontal positional relationships are based on the positional relationships in the drawings. Also, the dimensional proportions depicted in the drawings are not necessarily limitative. The term "(meth)acrylate" used throughout the present specification refers to the "acrylate" and its corresponding "methacrylate".

The term "polyvalent carboxylic acid condensate" used throughout the present specification means a polymer formed by condensation between the molecules of one or more polyvalent carboxylic acids with two or more carboxyl groups. More specifically, the polyvalent carboxylic acid condensate is a polymer wherein the carboxy groups between the molecules of a monomer with 2 or more molecules having 2 or more carboxyl groups undergo dehydrating condensation to produce acid anhydride groups (acid anhydride bonds), and each monomer unit is linked in a chain or cyclic fashion by the produced acid anhydride groups. The term "acid anhydride compound obtainable by intramolecular dehydrating condensation between the carboxyl groups of a polyvalent carboxylic acid" means an acid anhydride compound having a cyclic structure containing acid anhydride groups, the acid anhydride groups being produced by intramolecular dehydrating condensation between the carboxyl groups of a polyvalent carboxylic acid having 2 or more carboxyl groups.

[Polyvalent carboxylic acid condensate]

The polyvalent carboxylic acid condensate of the invention has a carboxyl group-containing compound that is intramolecularly condensed, and it has a constituent unit derived from the carboxyl group-containing compound which has solubility in water of no greater than 100 g/L at 30°C. As used herein, "solubility" refers to the weight of solute per 1 L of distilled water in a saturated aqueous solution obtained by dissolving the carboxyl group-containing compound in distilled water at 30°C.

Examples of carboxyle group-containing compounds having a solubility in water (30°C) of no greater than 100 g/L include tetrahydrophthalic acid (5 g/L), trimellitic acid (20 g/L), hexahydrophthalic acid (1.5 g/L), phthalic acid (9 g/L) and benzoic acid (4 g/L). Thus, the constituent unit derived from a carboxyle group-containing compound is preferably derived from at least one type of carboxyl group-containing compound selected from the group consisting of trimellitic acid, tetrahydrophthalic acid, phthalic acid, pyromellitic acid, fumaric acid and benzoic acid, and more preferably derived from trimellitic acid.

Examples of carboxyl group-containing compounds having solubility in water (30°C) exceeding 100 g/L include succinic acid (130 g/L), hydrogenated trimellitic acid (300 g/L) and maleic acid (800 g/L). When a polyvalent carboxylic acid condensate obtained by condensation of a carboxyl group-containing compound with a solubility in water (30°C)

exceeding 100 g/L is added as a curing agent to a thermosetting resin composition, the resin component elutes when the cured thermosetting resin composition is exposed to a strongly alkaline environment, and the surface of the cured product tends to become roughened.

The solubility in water (30°C) of the carboxyl group-containing compound composing the polyvalent carboxylic acid condensate according to this embodiment is preferably no greater than 50 g/L and more preferably no greater than 30 g/L.

Also, if the polyvalent carboxylic acid condensate of this embodiment has a constituent unit derived from a carboxyl group-containing compound with a solubility in water (30°C) of no greater than 100 g/L as an end group, its use as a curing agent for an epoxy resin will produce a cured product with even more excellent resistance to alkalis and even lower elution of the resin component.

The polyvalent carboxylic acid condensate of this embodiment preferably contains a component represented by the following general formula (1) as a major component.

[Chemical formula 6]

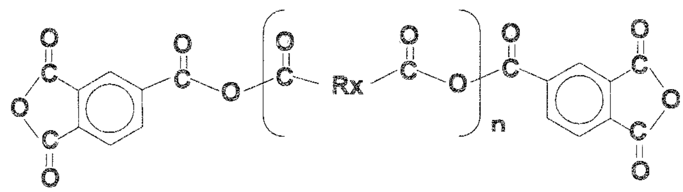

(1)

In formula (1), $R_x$ represents a divalent organic group and is preferably a divalent saturated hydrocarbon group with a saturated hydrocarbon ring. If $R_x$ is a saturated hydrocarbon group with a saturated hydrocarbon ring, the polyvalent carboxylic acid condensate will be able to form transparent cured epoxy resins. Multiple $R_x$ groups in the same molecule may be the same or different. The saturated hydrocarbon ring of $R_x$ may be optionally substituted with a halogen atom or a linear or branched hydrocarbon group. A hydrocarbon group substituting the saturated hydrocarbon ring is preferably a saturated hydrocarbon group. The saturated hydrocarbon ring may be a monocycle or a fused ring, polycyclo ring, spiro ring or ring cluster comprising two or more rings. The number of carbons in $R_x$ is preferably 3-15. Also, n represents an integer of 0 or greater, and n is preferably 0-200 and more preferably 0-100.

$R_x$ is a group derived by removing a carboxyl group from the polyvalent carboxylic acid used as the monomer to obtain the polymer represented by formula (1). The polyvalent carboxylic acid used as the monomer preferably has a higher boiling point than the reaction temperature for polycondensation.

More specifically, $R_x$ is preferably a divalent group derived by removing a hydrogen from a cyclic aliphatic hydrocarbon selected from among cyclobutane, cyclopentane, cyclohexane, cycloheptane, cyclooctane, norbornane, dicyclopentadiene, adamantane, naphthalene hydride and biphenyl hydride. If $R_x$ is one of these groups, a more notable effect of obtaining a transparent cured product with low coloration due to heating will be obtained. These cyclic saturated hydrocarbons may be optionally substituted with halogen atoms or linear or branched hydrocarbon groups (preferably saturated hydrocarbon groups).

Most preferably, $R_x$ is a group derived by removing a carboxyl group from 1,2-cyclohexanedicarboxylic acid, 1,3-cyclohexanedicarboxylic acid, 1,4-cyclohexanedicarboxylic acid, or one of their derivatives. That is, $R_x$ is preferably a divalent group represented by the following general formula (10). In formula (10), m represents an integer of 0-4. $R_z$ represents a halogen atom or a linear or branched C1-4 hydrocarbon group, When m is 2-4, the multiple $R_z$ groups may be the same or different and may even be linked together to form a ring.

[Chemical formula 7]

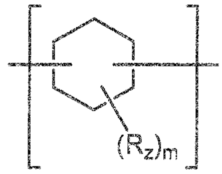

(10)

The weight-average molecular weight Mw of the polyvalent carboxylic acid condensate is preferably 200-20000 and more preferably 300-10000. If the weight-average molecular weight Mw is less than 200 the viscosity will be too low, tending to interfere with inhibiting resin smudge during transfer molding when it is used as a curing agent of the

thermosetting resin composition, while if it is greater than 20000 the compatibility with the epoxy resin will tend to be reduced, thus lowering the flow property during transfer molding of the thermosetting resin composition.

The weight-average molecular weight Mw for the purpose of then invention is the value obtained by measurement by gel permeation chromatography (GPC) using a calibration curve based on standard polystyrene, under the following conditions.

(GPC conditions)

Pump: L-6200 (trade name of Hitachi, Ltd.).
Columns: TSKgel-G5000HXL and TSKgel-G2000HXL (trade names of Tosoh Corp.)
Detector: Model L-3300RI (trade name of Hitachi, Ltd.).
Eluent: tetrahydroforan
Measuring temperature: 30°C.
Flow rate: 1.0 mL/min

The viscosity of the polyvalent carboxylic acid condensate as measured with an ICI cone-plate Brookfield viscometer is preferably 10-30000 mPa·s and more preferably 10-10000 mPa·s at 150°C. If the viscosity of the polyvalent carboxylic acid condensate is less than 10 mPa·s, for example, the effect of inhibiting resin smudge during transfer molding of the epoxy resin composition containing the polyvalent carboxylic acid condensate will tend to be lowered, while if it is greater than 30000 mPa·s the flow property of the thermosetting resin composition will tend to be reduced in the die during transfer molding. The viscosity of the polyvalent carboxylic acid condensate may be measured using an ICI cone-plate Brookfield viscometer by Research Equipment (London) Ltd., for example.

The softening point of the polyvalent carboxylic acid condensate is preferably 20-200°C. This will result in satisfactory dispersibility and workability when two roll mills or the like are used to disperse an inorganic filler in the resin composition comprising the polyvalent carboxylic acid condensate. Excellent inorganic filler dispersibility is especially important for a thermosetting resin composition for transfer molding.

From the viewpoint of kneadability during production of the thermosetting resin composition using a roll mill, the softening point of the polyvalent carboxylic acid condensate is preferably 30-100°C and more preferably 30-80°C. A softening point of below 20°C will tend to reduce the handleability, kneadability and dispersibility during production of the thermosetting resin composition, thus making it difficult to effectively inhibit resin smudge during transfer molding. A softening point of above 200°C may result in residual molten curing agent in the resin composition after heating at 100-200°C in transfer molding, thus making it difficult to obtain a homogeneous compact.

The softening point of the polyvalent carboxylic acid condensate can be adjusted to the desired range by selecting the main chain structure and varying the weight-average molecular weight. Generally speaking, using a long-chain divalent carboxylic acid as a monomer can lower the softening point, while introducing a highly polar structure can lower the softening point. The softening point can also usually be lowered with an increased weight-average molecular weight.

The ICI cone-plate viscosity, weight-average molecular weight and softening point of the polyvalent carboxylic acid condensate can be adjusted for the desired purpose by varying the charging compositional ratio of the polyvalent carboxylic acid and monocarboxylic acid before condensation reaction. A higher proportion of polyvalent carboxylic acid will tend to increase the ICI cone-plate viscosity, weight-average molecular weight and softening point. However, this tendency based on the condensation reaction conditions is not always exhibited, and factors such as the dehydrating condensation reaction conditions including the reaction temperature, degree of pressure reduction and reaction time must also be considered.

For example, the polyvalent carboxylic acid condensate of this embodiment can be obtained by a method comprising a step of intermolecular dehydrating condensation between carboxyl groups of a reaction mixture containing a polyvalent carboxylic acid represented by the following general formula (5) and a monocarboxylic acid represented by the following general formula (6).

[Chemical formula 8]

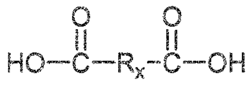 (5)

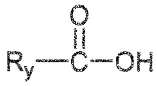 (6)

In formula (5), $R_x$ has the same definition as $R_x$ in the above formula (1). In formule (6), $R_y$ represents a monovalent hydrocarbon group optionally substituted with an acid anhydride group or a carboxylic acid ester group.

The dehydrating condensation reaction mixture comprises, for example, a polyvalent carboxylic acid and monocarboxylic acid, and a dehydrating agent that dissolves them, selected from among acetic anhydride or propionic anhydride, acetyl chloride, aliphatic acid chlorides, organic bases (trimethylamine and the like). For example, the reaction mixture is circulated for 5-60 minutes under a nitrogen atmosphere, and then the temperature of the reaction mixture is raised to 180°C for polycondensation in an open system under a nitrogen stream, distilling off the produced acetic acid and water. When no further volatilizing components are observed, polycondensation is continued in a molten state while reducing the pressure in the reactor with a temperature of 180°C for 3 hours, and more preferably 8 hours. The produced polyvalent carboxylic acid condensate may be purified by recrystallization or reprecipitation using an aprotic solvent such as acetic anhydride.

The polyvalent carboxylic acid condensate obtained by this method may contain by-products including condensation products between the two monocarboxylic acid molecules of formula (6), condensation products of the polyvalent carboxylic acid of formula (5) and the monocarboxylic acid of formula (6), unreacted polyvalent carboxylic acid and monocarboxylic acid, and acid anhydrides produced by condensation reaction between the reagents such as acetic anhydride and propionic anhydride and the polyvalent carboxylic acid or monocarboxylic acid. These by-products may be removed by purification, or they may be used in the mixture as curing agents.

[Thermosetting resin composition]

The thermosetting resin composition according to the invention comprises (A) an epoxy resin and (B) a curing agent.

<(A) Epoxy resin>

The (A) epoxy resin may be one commonly used in epoxy resin molding materials for sealing of electronic parts. As examples of epoxy resins there may be mentioned epoxidated novolac resins of phenols and aldehydes such as phenol-novolac-type epoxy resins and orthocresol-novolac-type epoxy resins, diglycidyl ethers of bisphenol A, bisphenol F, bisphenol S and alkyl-substituted bisphenols, glycidylamine-type epoxy resins obtained by reaction of epichlorohydrin with polyamines such as diaminodiphenylmethane and isocyanuric acid, linear aliphatic epoxy resins obtained by oxidation of olefin bonds with peracids such as peracetic acid, and alicyclic epoxy resins. Any of these may be used alone or in combinations of two or more.

Preferred of these are bisphenol A-type epoxy resins, bisphenol F-type epoxy resins, bisphenol S-type epoxy resins, diglycidyl isocyanurate, triglycidyl isocyanurate, and diglycidyl dicarboxylate esters derived from 1,2-cyclohexanedicarboxylic acid, 1,3-cyclohexanedicarboxylic acid or 1,4-cyclohexanedicarboxylic acid, because of their relatively low coloration. For the same reason, diglycidyl esters of dicarboxylic acids such as phthalic acid, tetrahydrophthalic acid, hexahydrophthalic acid, methyltetrahydrophthalic acid, nadic acid and methylnadic acid are preferred. There may also be mentioned glycidyl esters of nucleus-hydrogenated trimellitic acid and nucleus-hydrogenated pyromellitic acid having an alicyclic structure with hydrogenated aromatic rings. There may further be mentioned polyorganosiloxanes with epoxy groups, produced by heating a silane compound in the presence of an organic solvent, an organic base and water for hydrolysis and condensation. As component (A) there may be used an epoxy resin represented by the following formula (7), which is a copolymer of a glycidyl (meth)acrylate monomer and a monomer that is polymerizable therewith.

[Chemical formula 9]

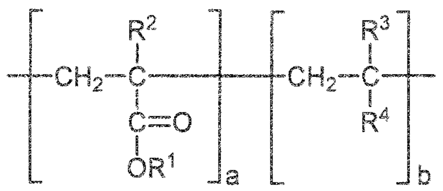

(7)

In formula (7), $R^1$ represents a glycidyl group, $R^2$ represents hydrogen or methyl group, $R^3$ represents hydrogen or a C1-6 saturated or unsaturated monovalent hydrocarbon group, and $R^4$ represents a monovalent saturated hydrocarbon group. The letters a and b represent positive integers.

In order to inhibit coloration of cured products, the epoxy resin is preferably an alicyclic epoxy resin having an aliphatic hydrocarbon group derived by removing a hydrogen atom from a cyclic aliphatic hydrocarbon selected from among cyclobutane, cyclopentane, cyclohexane, cycloheptane, cyclooctane, norbornane, dicyclopentadiene, adamantane, naphthalene hydride and biphenyl hydride. The cyclic aliphatic hydrocarbon may be optionally substituted with a halogen atom or a linear or branched hydrocarbon group.

From the viewpoint of minimizing resin smudges, the epoxy resin may be a 1,2-epoxy-4-(2-oxiranyl)cyclohexane addition product of 2,2-bis(hydroxymethyl)-1-butanol, which is available as a commercial product with the product name "EHPE3150" by Dicel Chemical Industries, Ltd.

<(B) Curing agent>

The curing agent of this embodiment may contain the above polyvalent carboxylic acid condensate. That is, the curing agent comprises a polyvalent carboxylic acid condensate in which a carboxyl group-containing compound is intramolecularly condensed, the polyvalent carboxylic acid condensate having a constituent unit derived from a carboxylic acid which has solubility in water of no greater than 100 g/L at 30°C. By including such a polyvalent carboxylic acid condensate, the (B) curing agent increases the resistance of cured products formed from the thermosetting resin composition, against alkaline degreasing solutions.

The (B) curing agent may further contain an acid anhydride formed by ring-closing condensation of a polyvalent carboxylic acid in the molecule. In this case, the equivalent ratio of epoxy groups in the (A) epoxy resin and polyacid anhydride groups in the (B) curing agent that are reactive with epoxy groups is preferably between 1:0.3 and 1:1.2. This can further minimize resin smudge during molding of the thermosetting resin composition of the invention.

In the thermosetting resin composition of this embodiment, a curing agent that is commonly used with epoxy resin molding materials for electronic part sealing may be used together with the polyvalent carboxylic acid condensate as the (B) curing agent. Such curing agents are not particularly restricted so long as they react with epoxy resins, but colorless or pale yellow agents are preferred. Examples of such curing agents include acid anhydride-based curing agents, isocyanuric acid derivative-based curing agents and phenol-based curing agents. Examples of acid anhydride-based curing agents include phthalic anhydride, maleic anhydride, trimellitic anhydride, pyromellitic anhydride, hexahydrophthalic anhydride, tetrahydrophthalic anhydride, methylnadic anhydride, nadic anhydride, glutaric anhydride, dimethylglutaric anhydride, diethylglutaric anhydride, succinic anhydride, methylhexahydrophthalic anhydride and methyltetrahydrophthalic anhydride. As isocyanuric acid derivatives there may be mentioned 1,3,5-tris(1-carboxymethyl)isocyanurate, 1,3,5-tris(2-carboxyethyl)isocyanurate, 1,3,5-tris(3-carboxypropyl)isocyanurate and 1,3-bis(2-carboxyethyl)isocyanurate. Preferred among these curing agents are phthalic anhydride, trimellitic anhydride, hexahydrophthalic anhydride, tetrahydrophthalic anhydride, methylhexahydrophthalic anhydride, methyltetrahydrophthalic anhydride, glutaric anhydride, dimethylglutaric anhydride, diethylglutaric anhydride and 1,3,5-tris(3-carboxypropyl)isocyanurate. These curing agents may be used alone or in combinations of two or more. When such compatible curing agents are included, the mixing ratio with the polyvalent carboxylic acid condensate is preferably adjusted to modify the overall viscosity of the (B) curing agent.

From the viewpoint of further increasing the resistance to alkalis of cured products formed from the thermosetting resin composition, the (B) curing agent may further comprise tetrahydrophthalic anhydride, a compound represented by the following formula (2), or trimellitic anhydride, a compound represented by the following formula (3).

[Chemical formula 10]

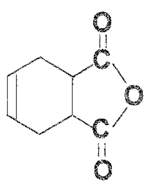
(2)
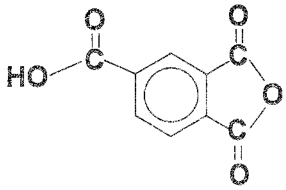
(3)

These compatible curing agents preferably have molecular weights of 100-400. Anhydrides having all of the aromatic ring unsaturated bonds hydrogenated are preferred over acid anhydrides having aromatic rings such as trimellitic anhydride or pyromellitic anhydride. As acid anhydride-based curing agents there may be used acid anhydrides that are commonly used as starting materials for polyimide resins.

The viscosity of the curing agent is preferably 1.0-1000 mPa·s and more preferably 10-200 mPa·s at 150°C, as measured with an ICI cone-plate Brookfield viscometer. If the viscosity of the curing agent is within this specified range, satisfactory moldability, with minimal burr generation, will be obtained when the curing agent-containing thermosetting resin composition is used for transfer molding. The method for adjusting the viscosity of the curing agent may be a method of adjusting the viscosity of the polyvalent carboxylic acid condensate by controlling the average molecular weight of the polyvalent carboxylic acid condensate, or a method of codifying the mixing ratio of the polyvalent carboxylic acid condensate and a curing agent that is compatible therewith.

The (B) curing agent may also be at least one type of acid anhydride selected from the group consisting of compounds represented by formula (1) above, compounds represented by formula (2) above and compounds represented by formula (3) above. If the (B) curing agent comprises at least one compound among the compounds represented by formulas (1) to (3) above, the thermosetting resin composition of the invention will have sufficiently excellent moldability and will be able to form a cured product with excellent resistance to alkalis, and sufficiently reduced elution of the resin component.

The content of the (B) curing agent in the thermosetting resin composition of the invention is preferably 10-150 parts by weight with respect to 100 parts by weight of the (A) epoxy resin, and from the viewpoint of inhibiting resin smudge it is more preferably 50-120 parts by weight.

The (B) curing agent preferably has, with respect to 1 equivalent of epoxy groups in the (A) epoxy resin, 0.5-0.9 equivalent and more preferably 0.7-0.8 equivalent of active groups (acid anhydride or hydroxyl groups) in the (B) curing agent that can react with the epoxy groups. With less than 0.5 equivalent of active groups, the thermosetting resin composition curing speed will be slowed and the glass transition temperature of the obtained cured product will be reduced, making it difficult to obtain an adequate elastic modulus. With greater than 0.9 equivalent of active groups, the post-curing strength will tend to be lower.

<(C) Curing accelerators

The thermosetting resin composition of the invention may contain a (C) curing accelerator if necessary. The (C) curing accelerator is not particularly limited so long as it has a catalyst function that promotes curing reaction between components (A) and (B). Examples of curing accelerators include amine compounds, imidazole compounds, organophosphorus compounds, alkali metal compounds, alkaline earth metal compounds and quaternary ammonium salts. Of these curing accelerators, amine compounds, imidazole compounds and organo-phosphorus compounds are preferably used. Examples of amine compounds include 1,8-diaza-bicyclo(5,4,0)undecene-7, triethylenediamine and tri-2,4,6-dimethylaminomethylphenol. Examples of imidazole compounds include 2-ethyl-4-methylimidazole. Examples of organo-phosphorus compounds include triphenylphosphine, tetraphenylphosphoniumtetraphenyl borate, tetra-n-butylphosphonium-o,o-diethylphosphorodithioate, tetra-n-butylphosphonium-tetrafluoroborate and tetra-n-butylphosphonium-tetraphenyl borate. These curing accelerators may be used alone or in combinations of two or more.

The content of the (C) curing accelerator is preferably 0.01-8 parts by weight and more preferably 0.1-3 parts by weight with respect to 100 parts by weight of the (A) epoxy resin. With a curing accelerator content of less than 0.01 part by weight it may not be possible to obtain a sufficient curing acceleration effect, and with a content of greater than 8 parts by weight the obtained compact may exhibit coloration.

<(D) White pigment>

When used as a white molding resin for use in a photosemiconductor device, the thermosetting resin composition of the invention preferably further comprises (D) a white pigment. The (D) white pigment used may be any known one,

without any particular restrictions. Examples of white pigments include alumina, magnesium oxide, antimony oxide, titanium oxide, zirconium oxide and inorganic hollow particles. Any of these may be used alone or in mixtures of two or more. Examples of inorganic hollow particles include sodium silicate glass, aluminum silicate glass, sodium borosilicate glass and white stand. The particle size of the white pigment is preferably a center particle size of 0.1-50 μm, as a center particle size of less than 0.1 μm will tend to promote aggregation and lower the dispersibility of the particles, while a size of greater than 50 μm will tend to make it difficult to obtain adequate reflectance properties for cured products of the thermosetting resin composition.

The (D) white pigment content is not particularly restricted but is preferably 10-85 vol% and more preferably 20-75 vol% with respect to the total thermosetting resin compositions. A content of less than 10 vol% will tend to make it difficult to obtain adequate photoreflectance properties for the cured thermosetting resin composition, while a content of greater than 85 vol% will tend to lower the moldability of the thermosetting resin composition.

When the thermosetting resin composition contains an inorganic filler as described hereunder in addition to the (D) white pigment, the total content of the (D) white pigment and inorganic filler may be 10-85 vol% with respect to the total thermosetting resin composition, to allow further improvement in the moldability of the thermosetting resin composition.

<Other components>

(Inorganic filler)

The thermosetting resin composition preferably contains an inorganic filler to adjust the moldability. The same inorganic fillers may be used as for the white pigment. Examples of inorganic fillers include silica, antimony oxide, titanium oxide, aluminum hydroxide, magnesium hydroxide, barium sulfate, magnesium carbonate, barium carbonate, alumina, mica, beryllia, barium titanate, potassium titanate, strontium titanate, calcium titanate, aluminum carbonate, aluminum silicate, calcium carbonate, calcium silicate, magnesium silicate, silicon nitride, boron nitride, clays such as calcined clay, talc, aluminum borate, aluminum borate and silicon carbide. From the viewpoint of thermal conductivity, photoreflectance, moldability and flame retardance, the inorganic filler is preferably a mixture of two or more selected from the group consisting of silica, alumina, magnesium oxide, antimony oxide, titanium oxide, zirconium oxide, aluminum hydroxide and magnesium hydroxide. The mean particle size of the inorganic filler is preferably 1-100 μm and more preferably 1-40 μm from the viewpoint of improving packing with the white pigment. The content of the inorganic filler in the thermosetting resin composition of this embodiment is preferably 1-1000 parts by weight and more preferably 1-800 parts by weight with respect to 100 parts by weight as the total of component (A) and component (B),

(Coupling agent)

The thermosetting resin composition preferably contains an added coupling agent from the viewpoint of enhancing the adhesion between the thermosetting resin components (A)-(C), the (D) white pigment and the inorganic filler which is added as necessary. Examples of coupling agents include silane coupling agents and titanate-based coupling agents, without any particular restrictions. As common silane coupling agents there may be mentioned epoxysilane-based, aminosilane-based, cationic silane-based, vinylsilane-based, acrylsilane-based and mercaptosilane-based agents, as well as their complex systems, and they may be used in any desired amounts. The coupling agent content is preferably no greater than 5 wt% with respect to the total thermosetting resin composition.

The thermosetting resin composition of this embodiment may contain additives such as antioxidants, release agents and ion scavengers, as necessary.

[Method for producing thermosetting resin composition]

The thermosetting resin composition of this embodiment can be obtained by uniformly dispersing and mixing each of the aforementioned components, without any particular restrictions on the means or conditions. A common method for producing thermosetting resin compositions is a method involving kneading the components with an extruding machine, kneader, roll, extruder or the like, cooling the kneaded blend, and pulverizing it. Kneading of the components is preferably carried out in a molten state from the viewpoint of improving the dispersibility. The kneading conditions may be appropriately set depending on the type and amount of each component, with kneading at 15-100°C for 5-40 minutes being preferred and kneading at 20-100°C for 10-30 minutes being more preferred. If the kneading temperature is below 15°C, kneading of each component will be more difficult, tending to lower the dispersibility, while if it is above 100°C the resin composition will be more highly molecularized, potentially hardening the resin composition. If the kneading time is shorter than 5 minutes, resin burrs may be generated during transfer molding. If the kneading time is longer than 40 minutes, the resin composition will be more highly molecularized, potentially hardening the resin composition.

The thermosetting resin composition of the invention can be produced by a pre-mixing step in which the (A) epoxy resin and (B) curing agent are pre-mixed, followed by addition of the other components and kneading with a roll mill or extruder. The pre-mixing step is preferred when, for example, either or both the (A) epoxy resin and (B) curing agent are liquid at 0-35°C, or have low viscosity of below 10 mPa·s at 100-200°C. The thermosetting resin composition obtained by pre-mixing using the (A) epoxy resin and (B) curing agent has improved, storage stability and exhibits excellent moldability during transfer molding.

The viscosity of the pre-mixture in the pre-mixing step is preferably 10-10000 mPa·s at 100-150°C, and the viscosity is preferably 10-10000 mPa·s at 100°C. A viscosity of lower than 10 mPa·s will tend to generate burrs during transfer molding, while a viscosity of higher than 10000 mPa·s will tend to lower the flow property during molding, thus impeding flow of the thermosetting resin composition into the die and reducing the moldability.

From the viewpoint of preventing increase in viscosity by generation of precipitates, the mixing conditions in the pre-mixing step, are preferably adjusted to avoid precipitation such as gelling of the cured reaction product of the (A) epoxy resin and (B) curing agent and consequent opacity of the pre-mixture due to precipitates. "Opacity due to precipitates" indicates scattering in the visible light range of the electromagnetic spectrum. More specifically, it indicates an absence of fine particles as scatter centers that produce Rayleigh scattering, Mie scattering and diffraction scattering of light.

In the pre-mixing step, specifically, a method may be employed in which 100 parts by weight of the (A) epoxy resin and 120 parts by weight of the (B) curing agent are weighed out into a heat-resistant glass container, and the mixture container is heated at 35-180°C using a heater with a fluid such as silicone oil or water as the medium. The heating method is not limited to this method, and a thermocouple, electromagnetic wave irradiation or the like may be used instead, or ultrasonic waves may be utilized to promote dissolution.

A portion of the (A) epoxy resin and (B) curing agent that are to be combined in the thermosetting resin composition may also be pre-mixed in the pre-mixing step. Specifically, for production of a thermosetting resin composition comprising 100 parts by weight of the (A) epoxy resin and 120 parts by weight of the (B) curing agent, first 50 parts by weight of the (A) epoxy resin and 120 parts by weight of the (B) curing agent are weighed out into a heat-resistant glass container and the mixture container is heated at 35-180°C using a heater with a fluid such as silicone oil or water as the medium, to obtain a pre-mixture. The obtained pre-mixture may then be mixed with the remaining 50 parts by weight of the (A) epoxy resin and the (C) curing accelerator and other components, by roll kneading or the like, to produce a thermosetting resin composition.

The thermosetting resin composition of this embodiment can be pressure molded into a tablet at near room temperature (15-30°C), and preferably the optical reflectance at a wavelength of 350-800 nm after thermosetting is 80% or greater. The pressure molding may be carried out under conditions of, for example, about 5-50 MPa for 1-5 seconds at room temperature. If the optical reflectance is less than 80% it may not be possible to sufficiently contribute to improved luminance of the photosemiconductor device; a more preferred optical reflectance range is 90% or greater.

The thermosetting resin composition of the invention preferably has a burr length of no greater than 5 mm when subjected to transfer molding under conditions with a molding temperature of 100°C-200°C, a molding pressure of 5-20 MPa and a molding time of 60-180 seconds. If the burr length is greater than 5 mm, resin smudge may occur in the opening (recess) which serves as the photosemiconductor element mounting region during fabrication of a photosemiconductor element mounting board, causing problems during mounting of photosemiconductor elements, and potentially hampering electrical connection between photosemiconductor elements and metal wirings. From the viewpoint of workability during semiconductor device production, the burr length is more preferably no greater than 3 mm and even more preferably no greater than 1 mm.

The thermosetting resin composition of this embodiment is useful for a variety of purposes including electrical insulating materials, photosemiconductor sealing materials, adhesive materials, coating materials and transfer molding epoxy resin molding materials, which require high heat resistance.

[Photosemiconductor element mounting board]

The semiconductor element mounting board of the invention has a recess composed of the bottom face and the wall faces, wherein the bottom face of the recess is the photosemiconductor element mounting section and at least parts of the wall faces of the recess are made of a cured thermosetting resin composition or epoxy resin molding material of the invention. Fig. 1 is a perspective view showing an embodiment of a photosemiconductor element mounting board of the invention. The photosemiconductor element mounting board 110 comprises a metal wiring 105 on which a Ni/Ag plating 104 is formed, and a reflector 103, and has a recess 200 formed from the metal wiring 105 on which the Ni/'Ag plating 104 is formed, and the reflector 103. That is, the bottom face of the recess 200 is composed of the metal wiring 105 on which the Ni/'Ag plating 104 is formed, while the wall face of the recess 200 is composed of the reflector 103, the reflector 103 being a compact comprising the cured thermosetting resin composition of the invention.

There are no particular restrictions on the method for producing the photosemiconductor element mounting

board of the invention, and for example, it may be produced by transfer molding using a thermosetting resin composition according to the invention. Fig. 2 is a schematic diagram showing an embodiment of a step for production of a photosemiconductor element mounting board of the invention. The photosemiconductor element mounting board can be produced, for example, by a step of forming a metal wiring 105 from a metal foil by a known method such as punching or etching and covering it with a Ni/Ag plating 104 by electroplating (Fig. 2(a)), followed by a step of placing the metal wiring 105 on a die 151 having a prescribed shape and injecting the thermosetting resin composition of the invention from the resin sprue 150 of the die 151 and performing transfer molding under prescribed conditions (Fig. 2(b)), further followed by a step of removing the die 151 (Fig. 2(c)). Thus, a photosemiconductor element mounting region (recess) 200 is formed surrounding a reflector 103 made of a cured thermosetting resin composition, on the photosemiconductor element mounting board. The transfer molding conditions are preferably 60-120 seconds with a mold temperature of 170-200°C and a molding pressure of 0.5-20 MPa, and 1-3 hours with an after-cure temperature of 120°C-180°C.

(Resin smudge-removal step)

When it is attempted to produce a photosemiconductor mounting board by transfer molding with a thermosetting resin composition, the resin composition generally exudes through the gap between the cope and drag of the molding die during molding, depending on the die design and molding conditions, often resulting in resin smudging. For example, when the die surface is mirror-finished, resin smudging tends to easily occur if the mold clamping pressure (clamp pressure) is low and the transfer injection pressure is high during transfer molding. However, if a thermosetting resin composition of the invention is used for transfer molding and no resin smudging has occurred, or photosemiconductor element connection can be accomplished in a later step, it is not always necessary to carry out a resin smudge-removal step.

When resin smudging is present in the openings of a board, a resin smudge-removal step is added to the production process to improve the solder wettability, plating property and die bond paste adhesive force of the metal surface exposed on the photosemiconductor element mounting board. An example of a removal step is a method of carrying out electrolytic degreasing treatment and dip degreasing treatment steps, followed by removal of the residual smudge components by high-pressure water rinsing or media blasting, or with an air gun. Electrolytic degreasing treatment is preferably used from the viewpoint of a shorter working time in degreasing treatment, although this is not limitative. In a deflush step, as a step for removal of residual smudge components, the smudge components may be removed by high-pressure water rinsing, media blasting, or with an air gun. From the viewpoint of minimizing damage to the resin sections, it is preferred to use high-pressure water rinsing or air gun spraying. Having conducted a deflush step, it is possible to subsequently proceed to the photosemiconductor element mounting step.

Fig. 3 is a schematic diagram showing a resin smudge-removal step according to this embodiment. First, as shown in Fig. 3(a), when resin smudging 502 is separately adhering on a reflector 500 made of a cured thermosetting resin composition formed on the lead frame 501 after the transfer molding, the prepared photosemiconductor element mounting board is dipped in a sodium hydroxide solution for alkaline electrolytic degreasing. Fig. 3(b) is a drawing showing the state of alkaline electrolytic degreasing in an alkaline electrolytic degreasing bath using a lead frame 501 as the cathode. Resin smudges 502 produced during molding rise up from the lead frame 501 by hydrogen gas 503 generated from the terminal surface in the electrochemical reaction by alkaline electrolytic degreasing, and are partially removed. The alkaline electrolytic degreasing treatment helps bring out the effect of deflushing by air blowing 506 in a subsequent step. Fig. 3(c) is a drawing showing a state in which some of the resin smudges 502 have been removed after alkaline electrolytic degreasing. Next, as shown in Fig. 3(d), deflushing is accomplished by the impact of air blowing 506, to remove the remaining resin smudges 502. Fig. 3(e) is a drawing showing a state in which the resin smudges 502 have been completely removed after deflushing. The method of deflushing is not limited to air blowing.

The following is an example of a treatment solution to be used for degreasing treatment. The treatment solution, however, is not limited to this.

As aqueous alkali solutions there may be used hydroxide solutions of alkali metals such as sodium hydroxide and potassium hydroxide, or of alkaline earth metals. It is suitable to employ a concentration of 10-200 g/L, a pH of 11-14 and a treatment temperature in the range of 20°C to 80°C, with a dip degreasing treatment time of 0.5 to 30 minutes. The concentration and treatment temperature conditions for electrolytic degreasing are the same as for dipping treatment, with a current density of 0.5 to 10 A/$dm^2$ and a treatment time in the range of 0.5 to 5 minutes. Electrolytic degreasing uses the lead frame of a photosemiconductor element mounting board as the cathode, and flow of current generates hydrogen gas from the terminal surface by electrochemical reaction. Because hydrogen gas leads to bubble formation, an appropriate amount of a surfactant or the like may be added as an additive to the aqueous alkali solution to efficiently accomplish degassing.

For a reflector produced using a thermosetting resin composition of the invention, it is possible to obtain high alkali resistance of the cured product and sufficiently reduce elution of the resin component, and therefore a satisfactory outer appearance can be maintained even after the aforementioned removal step.

[Photosemiconductor device]

The photosemiconductor device of the invention comprises the aforementioned photosemiconductor element mounting board, a photosemiconductor element provided in the recess of the photosemiconductor element mounting board, and a sealing resin section which fills the recess to seal the photosemiconductor element.

Fig. 4 is a perspective view showing an embodiment of the mounted state of a photosemiconductor element 100 on a photosemiconductor element mounting board 110 of the invention. As shown in Fig. 4, the photosemiconductor element 100 is mounted on a prescribed location of the photosemiconductor element mounting region (recess) 200 of the photosemiconductor element mounting board 110, and it is electrically connected by the metal wiring 105 and a bonding wire 102. Figs. 5 and 6 are schematic cross-sectional views each showing an embodiment of a photosemiconductor device according to the invention. As seen in Figs. 5 and 6, the photosemiconductor device comprises a photosemiconductor element mounting board 110, a photosemiconductor element 100 provided at a prescribed location inside the recess 200 of the photosemiconductor element mounting board 110, and a sealing resin section comprising a transparent sealing resin 101 containing a fluorescent material 106, which fills the recess 200 to seal the photosemiconductor element, wherein the photosemiconductor element 100 is electrically connected with the metal wiring 105 by a bonding wire 102 or solder bump 107.

Fig. 7 is also a schematic cross-sectional view showing an embodiment of a photosemiconductor device according to the invention. In the photosemiconductor device shown in Fig. 7, an LED element 300 is positioned on a lead 304 on which a reflector 303 is formed, via a die bond material 306, and the LED element 300 and lead 304 are electrically connected by a bonding wire 301, the LED element 300 being sealed by a transparent sealing resin 302 containing a fluorescent material 305.

The present invention is not in any way limited to the preferred embodiment described above.

## Examples

The present invention will now be explained in detail by examples, with the understanding that the invention is not limited to the examples.

<Preparation of polyvalent carboxylic acid condensate>

Each of the repeating unit monomers and end monomers in Synthesis Examples A1 and A3, and Comparative Synthesis Example A2 were circulated in acetic anhydride for 5-60 minutes under a nitrogen atmosphere, and then the temperature was raised to 180°C, and the acetic acid and water produced by the reaction in an open system under a nitrogen stream were removed. When no further volatilizing components were detected, the pressure inside the reactor was reduced while conducting melt condensation at a temperature of 180°C for 1-15 hours to obtain a polyvalent carboxylic acid condensate.

(Synthesis Example A1)

Repeating unit: 125 g of hydrogenated terephthalic acid (product of Tokyo Chemical industry Co., Ltd.)
Ends: 126 g of 1,2-trimellitic anhydride (product of Mitsubishi Gas Chemical Co., Inc.)

(Synthesis Example A3)

Repeating unit: 170 g of hydrogenated terephthalic acid (product of Tokyo Chemical Industry Co., Ltd.)
Ends: 195 g of 1,2-trimellitic anhydride (product of Mitsubishi Gas Chemical Co., Inc.)

(Comparative Synthesis Example A2)

Repeating unit: 125 g of hydrogenated terephthalic acid (product of Iwatani Gas Chemical Industry Co., Ltd.)
Ends: 126 g of hydrogenated 1,2-trimellitic anhydride (product of Mitsubishi Gas Chemical Co., Inc.)

<Evaluation of polyvalent carboxylic acid condensate properties >

The weight-average molecular weight, viscosity and softening point of each of the polyvalent carboxylic acid condensates of Synthesis Examples A1 and A3, and Comparative Synthesis Example A2 were evaluated. The results are shown in Table 1.

The weight-average molecular weight New was measured by gel permeation chromatography (GPC) using a calibration curve based on standard polystyrene, under the following conditions.

- Apparatus: Pump (Model L-6200, trade name of Hitachi, Ltd.), columns (TSKgcl-G5000HXL and TSKgel-G2000HXL, trade names of Tosoh Corp.) and detector (Model L-3300RI, trade name of Hitachi, Ltd.).
- Eluent: tetrahydrofuran, flow rate: 1.0 mL/min
- Measuring temperature: 30°C.

The viscosity measurement was conducted using an ICI cone-plate Brookfield viscometer by Research Equipment (LonCon) LTC.

The softening point was measured by a ring and ball softening point test based on JIS K 2207.

[Table 1]

| | Synthesis Example A1 | Synthesis Example A3 | Comparative Synthesis Example A2 |
|---|---|---|---|
| Weight-average molecular weight Mw | 1780 | 1088 | 1560 |
| Viscosity (ICI cone-plate, 150°C, mPa·s) | 200 | 390 | 400 |
| Softening point (°C) | 60-70 | 50-60 | 50-55 |

The polyvalent carboxylic acid condensates obtained in the Synthesis Examples A1 and A3 were very easily manageable in terms of both softening point and viscosity for production of thermosetting resin compositions, and they are suitable for use as curing agents in thermosetting resin compositions.

<Preparation of thermosetting resin compositions>

(Examples 1-11, Comparative Examples 1-10)

After premixing the (A) epoxy resin and (B) curing agent in the mixing ratios (by weight) listed in Tables 2-5, the remaining components were added and a mixer was used for thorough mixing, and then the mixture was melt kneaded with a mixing roll under prescribed conditions and cooled and pulverized to prepare thermosetting resin compositions for Examples 1-11 and Comparative Examples 1-10.

<Evaluation of thermosetting resin compositions>

Each of the obtained thermosetting resin compositions was used for transfer molding with an "ATOM-FX" transfer molding machine by MTEX under conditions with a molding die temperature of 180°C, a molding pressure of 6.9 MPa and a curing time of 90 seconds, and was evaluated in the following manner. The evaluation results are shown in Tables 2-5.

(Alkali resistance evaluation of cured products)

A 10 mm × 10 mm × 3 mm test piece prepared under the molding conditions described above was weighed before and after dipping in a sodium hydroxide aqueous solution, and the degree of elution of the cured product with respect to the aqueous alkali solution was evaluated. The dipping conditions were a sodium hydroxide aqueous solution concentration of 125 g/L, a dipping temperature of 50°C, and a dipping time of 5 minutes or 30 minutes. The dipped test piece was rinsed with water after dipping and subjected to ultrasonic treatment in water for a period of 30 seconds, re-rinsed with water, and then dried at 150°C for 30 minutes, after which the change in weight was measured.

$$\text{Weight change (\%)} = (\text{weight of test piece before dipping (g)} - \text{weight of test piece after dipping (g)})/\text{weight of test piece before dipping (g)} \times 100$$

(Evaluation of resin smudge removal)

Each of the obtained thermosetting resin compositions was used for molding with an "ATOM-FX" transfer molding machine by MTEX, under conditions with a molding die temperature of 180°C, a clamp pressure of 20 t, an injection pressure of 7 MPa and a molding time of 90 seconds, to fabricate a photosemiconductor element mounting board.

As lead frames there were used test lead frames allowing formation of 12 photosemiconductor element mounting boards with an opening outer periphery of 10 mm × 1 to mm for each lead frame (2 rows × 6 column). The metal wiring to serve as the photosemiconductor element mounting region on the lead frame was designed as a pattern having 3 pairs each of cathodes and anodes in each photosemiconductor element mounting region, using a copper lead frame with a thickness of 0.25 μm, surface-plated with Ag.

The photosemiconductor element mounting board having resin smudge on the lead frame was used for electrolytic degreasing with an aqueous alkali solution, and after rinsing the board while applying ultrasonic waves for 30 seconds, the resin smudge (burr formation) was removed by air blowing. The presence or absence of residual resin smudge after deflushing, and the outer appearance of the reflector section (surface roughness and degree of elution) were evaluated based on the following.

A: No change in outer appearance.
B: Virtually no change in outer appearance, but some elution occurred.
C: Irregularities due to elution of resin components from the cured product.

[Table 2]

| | | | Example | | | | |
|---|---|---|---|---|---|---|---|
| | | | 1 | 2 | 3 | 4 | 5 |
| Epoxy resin | Trisglycidyl isocyanurate | (*1) | 20.0 | 20.0 | 20.0 | 20.0 | 20.0 |
| | MMA-GMA copolymer | (*2) | - | - | - | - | - |
| | Bisphenol A epoxy resin | (*3) | - | - | - | - | - |
| Curing agent | Synthesis Example A1 | | 3.6 | 3.6 | 3.6 | 3.6 | 3.6 |
| | Comprehensive Synthesis Example A2 | | - | - | - | - | - |
| | Tetrahydrophthalic anhydride | (*4) | - | 8.6 | 10.7 | 12.9 | 15.0 |
| | Trimellitic anhydride | (*5) | - | - | - | - | - |
| | Succinic anhydride | (*6) | 7.2 | | - | - | - |
| | Hexahydrophthalic anhydride | (*7) | 6.5 | 8.6 | 6.5 | 4.3 | 2.2 |
| Curing accelerator | Tetra-n-butylphosphonium tetraphenolborate | (*8) | 0.7 | 0.7 | 0.6 | 0.4 | 0.4 |
| | Tetra-n-butylphosphonium-o,o-diethyl phosphorodithioate | (*9) | - | - | - | - | - |
| Coupling agent | Triethoxyaminosilane | (*10) | - | - | - | - | - |
| | Trimethoxyepoxysilane | (*11) | 0.4 | 0.5 | 0.5 | 0.5 | 0.5 |
| Inorganic filter | FB-950 | (*12) | 62 | 75 | 75 | 109 | 109 |
| | SO-25R | (*13) | 16 | 19 | 19 | 17 | 17 |
| White pigment | S60-HS | (*14) | 21 | 26 | 25 | 23 | 23 |
| | CR-63 | (*15) | 74 | 89 | 89 | 80 | 80 |

(continued)

| | | Example | | | | |
|---|---|---|---|---|---|---|
| | | 1 | 2 | 3 | 4 | 5 |
| Alkali resistance | Weight reduction after 5 min dipping treatment (%) | 0.60 | 0.21 | 0.25 | 0.31 | 0.12 |
| | Weight reduction after 30 min dipping treatment (%) | 2.30 | 1.82 | 1.94 | 1.56 | 1.56 |
| Outer appearance | Residual burrs | None | None | None | None | None |
| | Surface roughness | B | A | A | A | A |

[Table 3]

| | | | Example | | | | | |
|---|---|---|---|---|---|---|---|---|
| | | | 6 | 7 | 8 | 9 | 10 | 11 |
| Epoxy resin | Trisglycidyl isocyanurate | (*1) | 20.0 | 20.0 | 20.0 | 20.0 | 20.0 | 20.0 |
| | MMA-GMA copolymer | (*2) | - | - | - | 1.7 | - | - |
| | Bisphenol A epoxy resin | (*3) | - | - | - | - | 1.8 | - |
| Curing agent | Synthesis Example A1 | | 1.8 | - | - | 3.6 | 3.6 | - |
| | Synthesis Example A3 | | - | - | - | - | - | 3.6 |
| | Comprehensive Synthesis Example A2 | | - | - | - | - | - | - |
| | Tetrahydrophthalic anhydride | (*4) | - | 15.0 | - | 15.4 | 15.0 | - |
| | Trimellitic anhydride | (*5) | 1.8 | - | 3.6 | - | - | - |
| | Succinic anhydride | (*6) | 7.2 | - | 7.2 | - | - | 7.2 |
| | Hexahydrophthalic anhydride | (*7) | 8.3 | 6.5 | 8.3 | 6.5 | 6.5 | 6.5 |
| Curing accelerator | Tetra-n-butylphosphonium tetraphenolborate | (*8) | 0.7 | 0.7 | 0.6 | 0.4 | 0.4 | 0.7 |
| | Tetra-n-butylphosphonium-o,o-diethyl phosphorodithioate | (*9) | - | - | - | - | - | - |
| Coupling agent | Triethoxyaminosilane | (*10) | - | - | - | - | - | - |
| | Trimethoxyepoxysilane | (*11) | 0.5 | 0.5 | 0.5 | 0.5 | 0.5 | 0.4 |
| Inorganic filter | FB-950 | (*12) | 112 | 112 | 112 | 98 | 83 | 62 |
| | SO-25R | (*13) | 17 | 17 | 17 | 22 | 20 | 16 |
| White pigment | S60-HS | (*14) | 24 | 24 | 24 | 30 | 28 | 21 |
| | CR-63 | (*15) | 82 | 82 | 82 | 103 | 99 | 74 |
| Alkali resistance | Weight reduction after 5 min dipping treatment (%) | | 0.45 | 0.24 | 0.35 | 0.31 | 0.26 | 0.60 |
| | Weight reduction after 30 min dipping treatment (%) | | 2.69 | 1.56 | 2.11 | 1.42 | 1.56 | 2.30 |

(continued)

| | | Example | | | | | |
|---|---|---|---|---|---|---|---|
| | | 6 | 7 | 8 | 9 | 10 | 11 |
| Outer appearance | Residual burrs | None | None | None | None | None | None |
| | Surface roughness | B | A | B | A | A | A |

[Table 4]

| | | | Comparative Example | | | | |
|---|---|---|---|---|---|---|---|
| | | | 1 | 2 | 3 | 4 | 5 |
| Epoxy resin | Trisglycidyl isocyanurate | (*1) | 20.0 | 20.0 | 20.0 | 20.0 | 20.0 |
| | MMA-GMA copolymer | (*2) | - | - | - | - | - |
| | Bisphenol A epoxy resin | (*3) | - | - | - | - | - |
| Curing agent | Synthesis Example A1 | | - | - | - | - | - |
| | Comprehensive Synthesis Example A2 | | 3.6 | 3.6 | 3.6 | 3.6 | 3.6 |
| | Tetrahydrophthalic anhydride (*4) | | - | - | - | - | - |
| | Trimellitic anhydride | (*5) | - | - | - | - | - |
| | Succinic anhydride | (*6) | 10.7 | 10.7 | 10.0 | 7.2 | 7.2 |
| | Hexahydrophthalic anhydride | (*7) | 2.2 | 2.2 | 2.2 | 6.4 | 6.4 |
| Curing accelerator | Tetra-n-butylphosphonium tetraphenolborate | (*8) | 0.7 | - | 0.5 | 0.5 | 0.7 |
| | Tetra-n-butylphosphonium-o,o-diethyl phosphorodithioate | (*9) | - | 0.3 | - | - | - |
| Coupling agent | Triethoxyaminosilane | (*10) | 0.2 | - | - | - | - |
| | Trimethoxyepoxysilane | (*11) | - | 0.2 | 0.4 | 0.4 | 0.4 |
| Inorganic filter | FB-950 | (*12) | 17 | 16 | 59 | 62 | 62 |
| | SO-25R | (*13) | 15 | 15 | 15 | 15 | 15 |
| White pigment | S60-HS | (*14) | 21 | 20 | 20 | 21 | 21 |
| | CR-63 | (*15) | 73 | 71 | 71 | 74 | 74 |
| Alkali resistance | Weight reduction after 5 min dipping treatment (%) | | 2.50 | 1.24 | 1.54 | 1.10 | 1.87 |
| | Weight reduction after 30 min dipping treatment (%) | | 7.64 | 8.62 | 6.73 | 5.43 | 6.84 |
| Outer appearance | Residual burrs | | None | None | None | None | None |
| | Surface roughness | | C | C | C | C | C |

[Table 5]

| | | | Comparative Example | | | | |
|---|---|---|---|---|---|---|---|
| | | | 6 | 7 | 8 | 9 | 10 |
| Epoxy resin | Trisglycidyl isocyanurate | (*1) | 20.0 | 20.0 | 20.0 | 20.0 | 20.0 |
| | MMA-GMA copolymer | (*2) | - | - | - | 1.7 | - |
| | Bisphenol A epoxy resin | (*3) | - | - | - | - | 1.8 |
| Curing agent | Synthesis Example A1 | | - | - | - | - | - |
| | Comprehensive Synthesis Example A2 | | 3.6 | 6.1 | 6.1 | 3.8 | 3.6 |
| | Tetrahydrophthalic anhydride | (*4) | - | - | - | - | - |
| | Trimellitic anhydride | (*5) | - | - | - | - | - |
| | Succinic anhydride | (*6) | 7.2 | 12.2 | 14.2 | 17.6 | - |
| | Hexahydrophthalic anhydride | (*7) | 6.4 | 2.5 | - | - | 17.2 |
| Curing accelerator | Tetra-n-butylphosphonium tetraphenolborate | (*8) | 0.5 | 0.8 | 0-8 | 0.5 | 0.6 |
| | Tetra-n-butylphosphonium-o,o-diethyl phosphorodithioate | (*9) | 0.02 | - | - | 2.2 | 0.02 |
| Coupling agent | Triethoxyaminosilane | (*10) | - | - | - | - | - |
| | Trimethoxyepoxysilane | (*11) | 0.4 | 0.4 | 0.4 | 0.7 | 0.4 |
| Inorganic filter | FB-950 | (*12) | 63 | 69 | 68 | 75 | 72 |
| | SO-25R | (*13) | 16 | 17 | 17 | 19 | 18 |
| White pigment | S60-HS | (*14) | 21 | 23 | 23 | 25 | 24 |
| | CR-63 | (*15) | 75 | 82 | 81 | 89 | 85 |
| Alkali resistance | Weight reduction after 5 min dipping treatment (%) | | 1.46 | 2.13 | 2.42 | 2.97 | 1.32 |
| | Weight reduction after 30 min dipping treatment (%) | | 3.61 | 8.58 | 9.78 | 11.2 | 4.32 |

(continued)

| | | Comparative Example | | | | |
|---|---|---|---|---|---|---|
| | | 6 | 7 | 8 | 9 | 10 |
| Outer appearance | Residual burrs | None | None | None | None | None |
| | Surface roughness | C | C | C | C | C |

Footnotes *1-*15 in Tables 2-5 are as follows.
*1: Trisglycidyl isocyanurate (epoxy equivalents: 100, trade name: TEPIC-S by Nissan Chemical Industries, Ltd.)
*2: Methyl methacrylate - Glycidyl methacrylate copolymer (epoxy equivalents: 181, weight-average molecular weight: 10000, Trade name: CP50M by NOF Co.)
*3: Bisphenol A epoxy resin (epoxy equivalents: 450, weight-average molecular weight: 900, trade name: EPIKOTE 1001 by Japan Epoxy Resins Co. Ltd.)
*4: Tetrahydrophthalic anhydride (trade name: LICASID TH by New Japan Chemical Co., Ltd.)
*5: Trimellitic anhydride (trade name: TMA by Mitsubishi Gas Chemical Co., Inc.)
*6: Succinic anhydride (trade name: LICASID SA by New Japan Chemical Co., Ltd.)
*7: Hexahydrophthalic anhydride (trade name: LICASID HH by New Japan Chemical Co., Ltd.)
*8: Tetra-n-butylphosphonium-o,o-diethyl phosphorodithioate (trade name: PX-4ET by Nippon Chemical Industrial Co., Ltd.)
*9: Tetra-n-butylphosphonium tetraphenylborate (trade name: PX-4PB by Nippon Chemical Industrial Co., Ltd.)
*10: Triethoxyaminosilane (trade name: Z6011 by Dow Coming Toray Co., Ltd.)
*11: Trimethoxyepoxysilane (trade name: S6040 by Dow Coming Toray Co., Ltd.)
*12: Molten silica (trade name: FB-950 by Denki Kagaku Kogyo Co., Ltd.)
*13: Molten silica (trade name: SO-25R by Denki Kagaku Kogyo Co., Ltd.)
*14: Hollow particles (trade name: S60-HS by Sumitomo-3M)
*15: Titanium oxide (trade name: CR-63 by Ishihara Sangyo Kaisha, Ltd.)

As shown in Tables 2 and 3, the thermosetting resin compositions of the invention have low weight variation rates before and after dipping treatment and excellent resistance to alkalis, compared to the thermosetting resin compositions of the comparative examples. Transfer molding using a thermosetting resin composition of the invention can adequately remove resin smudges without impairing the outer appearance of reflectors on lead frames.

Using a thermosetting resin composition of the invention for transfer molding can yield a photosemiconductor element mounting board having a photosemiconductor element mounting region with reduced resin smudge. This allows a photosemiconductor element to be mounted in the opening of the photosemiconductor element mounting region and electrical connection to be established between the photosemiconductor element and metal wiring by a known method such as a bonding wire.

## Industrial Applicability

According to the invention it is possible to provide a thermosetting resin composition with sufficiently excellent moldability, excellent resistance to alkalis, and sufficiently reduced elution of resin components, as well as a photosemiconductor element mounting board and method for producing it, and a photosemiconductor device, which employ the same.

## Explanation of Symbols

100: Photosemiconductor element, 101: transparent sealing resin, 102: bonding wire, 103: cured thermosetting resin composition (deflector), 104: Ni/Ag plating, 105: metal wiring, 106: fluorescent material, 107: solder bump, 110: photosemiconductor element mounting board, 200: photosemiconductor element mounting region, 150: resin sprue, 151: dire, 300: LED element, 301: bonding wire, 302: transparent sealing resin, 303: reflector, 304: lead, 305: fluorescent material, 306: die bond material, 500: cured thermosetting resin composition (reflector), 501: lead frame (electrode), 502: resin smudge, 503: hydrogen gas generated from electrode, 506: state of air blowing.

## Claims

**1.** A polyvalent carboxylic acid condensate in which a carboxyl group-containing compound is intramolecularly condensed,
the polyvalent carboxylic acid condensate having a constituent unit derived from the carboxyl group-containing compound which has solubility in water of no greater than 100 g/L at 30°C, and
comprising a component represented by the following general formula (I):

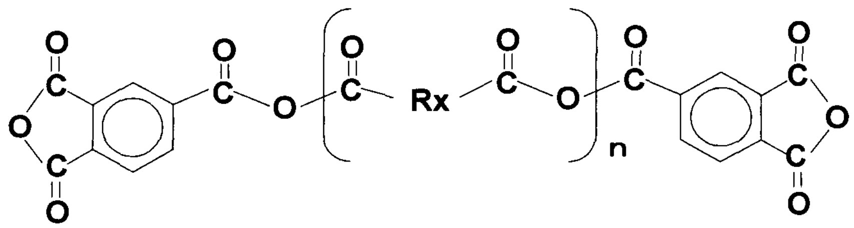

(1)

wherein $R_x$ is a divalent organic group with an aliphatic hydrocarbon ring, and the aliphatic hydrocarbon ring is optionally substituted with a halogen atom or a linear or branched hydrocarbon group, multiple $R_x$ groups in the same molecule may be the same or different, and n represents an integer of 0 or greater,
wherein "solubility" refers to the weight of solute per 1 L of distilled water in a saturated aqueous solution obtained by dissolving the carboxyl group-containing compound in distilled water at 30°C.

**2.** The polyvalent carboxylic acid condensate according to claim 1, wherein $R_x$ is a divalent group represented by the following general formula (10):

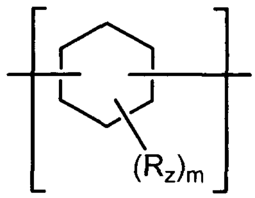

(10)

wherein m represents an integer of 0-4, $R_z$ represents a halogen atom or linerar or branched C 1-4 hydrocarbon group, and when m is 2-4 the multiple $R_z$ groups may be the same or different and linked together to form a ring.

**3.** A thermosetting resin composition comprising (A) an epoxy resin and (B) a curing agent,
wherein the (B) curing agent contains a polyvalent carboxylic acid condensate according to any one of claims 1 or 2.

**4.** The thermosetting resin composition according to claim 3, wherein the curing agent further contains a compound represented by formula (2).

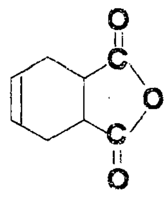

(2)

**5.** The thermosetting resin composition according to claim 3, wherein the curing agent further contains a compound represented by formula (3).

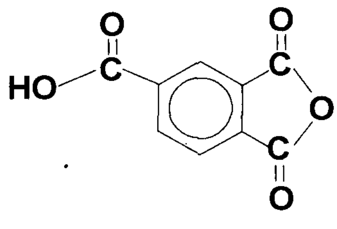

(3)

6. The thermosetting resin composition according to any one of claims 3 to 5, wherein the content of the polyvalent carboxylic acid condensate is 10-150 parts by weight with respect to 100 parts by weight of the (A) epoxy resin.

7. The thermosetting resin composition according to any one of claims 3 to 6, wherein the equivalent ratio of epoxy groups in the (A) epoxy resin and acid anhydride groups in the (B) curing agent that are reactive with the epoxy groups is between 1:0.3 and 1:1.2.

8. The thermosetting resin composition according to any one of claims 3 to 7, further comprising (D) a white pigment.

9. The thermosetting resin composition according to claim 8, wherein the (D) white pigment includes at least one inorganic material selected from the group consisting of alumina, magnesium oxide, antimony oxide, titanium oxide, zirconium oxide and inorganic hollow particles.

10. A photosemiconductor element mounting board, having a recess composed of the bottom face and the wall faces, wherein the bottom face of the recess is the photosemiconductor element mounting section and at least parts of the wall faces of the recess are made of a cured thermosetting resin composition according to any one of claims 3 to 9.

11. A method for producing a photosemiconductor element mounting board having a recess composed of the bottom face and the wall faces, comprising:

a step of forming at least parts of the wall faces of the recess using the thermosetting resin composition according to any one of claims 3 to 9.

12. A photosemiconductor device comprising:

a photosemiconductor element mounting board having a recess composed of the bottom face and the wall faces, a photosemiconductor element disposed in the recess of the photosemiconductor element mounting board and a sealing resin section in which the recess is filled to seal the photosemiconductor element,
wherein at least parts of the wall faces of the recess are made of a cured thermosetting resin composition according to any one of claims 3 to 9.

**Patentansprüche**

1. Mehrwertiges Carbonsäurekondensat, in dem eine Carboxylgruppen-enthaltende Verbindung intramolekular kondensiert ist,
wobei das mehrwertige Carbonsäurekondensat eine Aufbaueinheit aufweist, die abgeleitet ist von einer Carboxylgruppen-enthaltenden Verbindung, die eine Löslichkeit in Wasser von nicht mehr als 100 g/L bei 30°C aufweist, und wobei das mehrwertige Carbonsäurekondensat eine Komponente der folgenden allgemeinen Formel (I) umfasst:

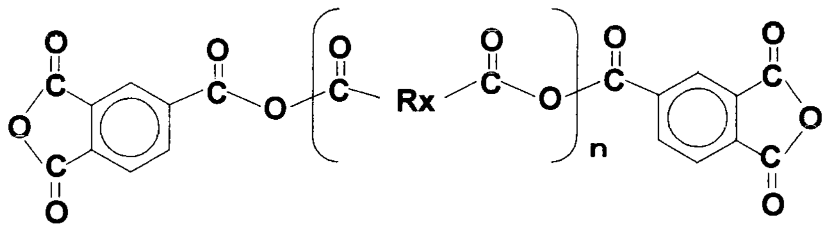

(1)

wobei gilt: $R_x$ ist eine zweiwertige organische Gruppe mit einem aliphatischen Kohlenwasserstoffring, und der aliphatische Kohlenwasserstoffring ist optional substituiert mit einem Halogenatom oder einer linearen oder verzweigten Kohlenwasserstoffgruppe, wobei mehrere $R_x$-Gruppen im gleichen Molekül gleich oder verschieden sein können, und n steht für eine ganze Zahl von 0 oder größer,
wobei "Löslichkeit" bezeichnet: das Gewicht an gelöstem Stoff pro 1 L destillierten Wassers in einer gesättigten wässrigen Lösung, erhalten durch Auflösen der Carboxylgruppen-enthaltenden Verbindung in destilliertem Wasser bei 30°C.

2. Mehrwertiges Carbonsäurekondensat nach Anspruch 1, wobei gilt: $R_x$ ist eine zweiwertige Gruppe der folgenden

allgemeinen Formel (10):

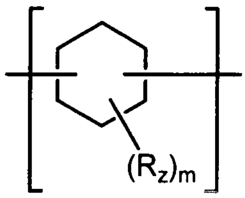

(10)

wobei gilt: m steht für eine ganze Zahl von 0 bis 4, $R_Z$ steht für ein Halogenatom oder eine lineare oder verzweigte C1-4-Kohlenwasserstoffgruppe, und wenn m 2-4 ist, können die mehreren $R_Z$-Gruppen gleich oder verschieden und miteinander verbunden sein, um einen Ring zu bilden.

**3.** Hitzehärtbare Harzzusammensetzung, umfassend (A) ein Epoxyharz und (B) ein Härtungsmittel, wobei das (B) Härtungsmittel ein mehrwertiges Carbonsäurekondensat nach einem der Ansprüche 1 oder 2 enthält.

**4.** Hitzehärtbare Harzzusammensetzung nach Anspruch 3, wobei das Härtungsmittel des Weiteren eine Verbindung der Formel (2) enthält.

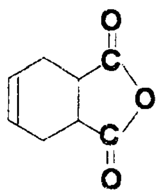

( 2 )

**5.** Hitzehärtbare Harzzusammensetzung nach Anspruch 3, wobei das Härtungsmittel des Weiteren eine Verbindung der Formel (3) enthält.

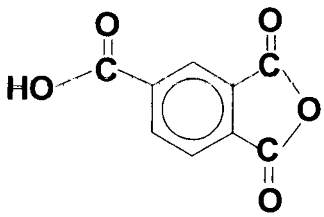

(3)

**6.** Härtbare Harzzusammensetzung nach einem der Ansprüche 3 bis 5, wobei der Gehalt des mehrwertigen Carbonsäurekondensats 10-150 Gewichtsteile bezogen auf 100 Gewichtsteile des (A) Epoxyharzes beträgt.

**7.** Hitzehärtbare Harzzusammensetzung nach einem der Ansprüche 3 bis 6, wobei das Äquivalenzverhältnis von Epoxygruppen in dem (A) Epoxyharz und Säureanhydrid in dem (B) Härtungsmittel, die mit den Epoxygruppen reagieren können, zwischen 1:0,3 und 1:1,2 liegt.

**8.** Hitzehärtbare Harzzusammensetzung nach einem der Ansprüche 3 bis 7, des Weiteren umfassend (D) ein weißes Pigment.

**9.** Hitzehärtbare Harzzusammensetzung nach Anspruch 8, wobei das (D) weiße Pigment umfasst: mindestens ein anorganisches Material, ausgewählt aus der Gruppe, bestehend aus Aluminiumoxid, Magnesiumoxid, Antimonoxid, Titanoxid, Zirconiumoxid und anorganischen hohlen Teilchen.

**10.** Photohalbleiterelement-Befestigungsplatte mit einer Vertiefung, bestehend aus der Bodenfläche und den Wandflächen, wobei die Bodenfläche der Vertiefung der Photohalbleiterelement-Befestigungsbereich ist und mindestens Teile der Wandflächen der Vertiefung hergestellt sind aus einer gehärteten hitzehärtbaren Harzzusammensetzung gemäß einem der Ansprüche 3 bis 9.

11. Verfahren zur Herstellung einer Photohalbleiterelement-Befestigungsplatte mit einer Vertiefung, bestehend aus der Bodenfläche und den Wandflächen, umfassend:

eine Stufe des Bildens von mindestens Teilen der Wandflächen der Vertiefung unter Verwendung der hitzehärtbaren Harzzusammensetzung nach einem der Ansprüche 3 bis 9.

12. Photohalbleitervorrichtung, umfassend:

eine Photohalbleiterelement-Befestigungsplatte mit einer Vertiefung, bestehend aus der Bodenfläche und den Wandflächen,
ein Photohalbleiterelement, das in der Vertiefung der Photohalbleiterelement-Befestigungsplatte angeordnet ist und
einen Dichtungsharzbereich, in dem die Vertiefung gefüllt ist, um das Photohalbleiterelement abzudichten,
wobei mindestens Teile der Wandflächen der Vertiefung hergestellt sind aus einer gehärteten hitzehärtbaren Harzzusammensetzung nach einem der Ansprüche 3 bis 9.

## Revendications

1. Condensat d'acide carboxylique polyvalent dans lequel un composé contenant un groupe carboxyle est condensé de manière intramoléculaire,
le condensat d'acide carboxylique polyvalent contenant un motif constitutif dérivé du composé contenant un groupe carboxyle qui présente une solubilité dans l'eau qui n'est pas supérieure à 100 g/l à 30 °C, et
comprenant un composé représenté par la formule générale (I) suivante :

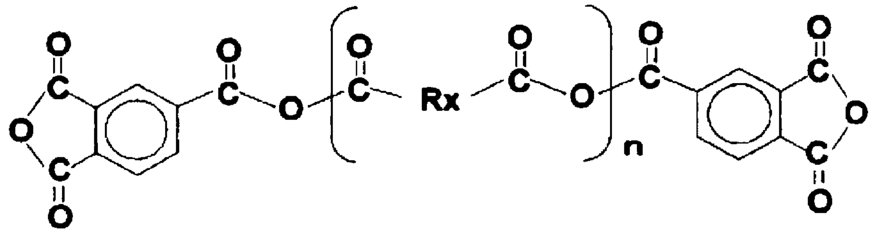

( 1 )

dans laquelle $R_x$ est un groupe organique divalent ayant un cycle hydrocarboné aliphatique, et le cycle hydrocarboné aliphatique est facultativement substitué avec un atome d'halogène ou un groupe hydrocarboné linéaire ou ramifié, de multiples groupes $R_x$ dans la même molécule peuvent être identiques ou différents, et n représente un nombre entier supérieur ou égal à 0,
dans lequel « solubilité » fait référence au poids d'un soluté pour 1 l d'eau distillée dans une solution aqueuse saturée obtenue par la dissolution du composé contenant un groupe carboxyle dans de l'eau distillée à 30 °C.

2. Condensat d'acide carboxylique polyvalent selon la revendication 1, dans lequel $R_x$ est un groupe divalent représenté par la formule générale (10) suivante :

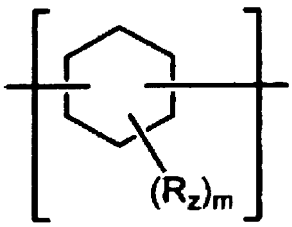

(10)

dans laquelle m représente un nombre entier allant de 0 à 4, $R_z$ représente un atome d'halogène ou un groupe hydrocarboné en $C_1$ à $C_4$ linéaire ou ramifié, et quand m est 2 à 4, les multiples groupes $R_z$ peuvent être identiques ou différents et liés ensemble pour former un cycle.

3. Composition de résine thermodurcissable comprenant (A) une résine époxy et (B) un agent de durcissement,

dans laquelle l'agent de durcissement (B) contient un condensat d'acide carboxylique polyvalent selon l'une quelconque des revendications 1 ou 2.

**4.** Composition de résine thermodurcissable selon la revendication 3, dans laquelle l'agent de durcissement contient en outre un composé représenté par la formule (2).

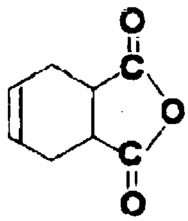

(2)

**5.** Composition de résine thermodurcissable selon la revendication 3, dans laquelle l'agent de durcissement contient en outre un composé représenté par la formule (3).

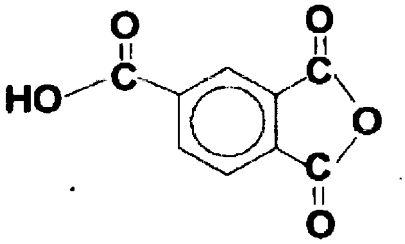

(3)

**6.** Composition de résine thermodurcissable selon l'une quelconque des revendications 3 à 5, dans laquelle la teneur du condensat d'acide carboxylique polyvalent est de 10 à 150 parties en poids par rapport à 100 parties en poids de la résine époxy (A).

**7.** Composition de résine thermodurcissable selon l'une quelconque des revendications 3 à 6, dans laquelle le rapport des équivalents des groupes époxy dans la résine époxy (A) et des groupes anhydride d'acide dans l'agent de durcissement (B) qui sont réactifs avec les groupes époxy est situé entre 1 : 0,3 et 1 : 1,2.

**8.** Composition de résine thermodurcissable selon l'une quelconque des revendications 3 à 7, comprenant en outre (D) un pigment blanc.

**9.** Composition de résine thermodurcissable selon la revendication 8, dans laquelle le pigment blanc (D) comprend au moins un matériau inorganique choisi dans le groupe constitué par l'alumine, l'oxyde de magnésium, l'oxyde d'antimoine, l'oxyde de titane, l'oxyde de zirconium et des particules creuses inorganiques.

**10.** Carte de montage d'élément photosemi-conducteur, présentant un renfoncement composé de la face inférieure et des faces de paroi,
dans laquelle la face inférieure du renfoncement est la section de montage de l'élément photosemi-conducteur et au moins des parties des faces de paroi du renfoncement sont faites d'une composition de résine thermodurcissable durcie selon l'une quelconque des revendications 3 à 9.

**11.** Procédé de production d'une carte de montage d'élément photosemi-conducteur présentant un renfoncement composé de la face inférieure et des faces de paroi, comprenant :

une étape de formation d'au moins des parties des faces de paroi du renfoncement en utilisant la composition de résine thermodurcissable selon l'une quelconque des revendications 3 à 9.

**12.** Dispositif photosemi-conducteur comprenant :

une carte de montage d'élément photosemi-conducteur présentant un renfoncement composé de la face inférieure et des faces de paroi,

un élément photosemi-conducteur disposé dans le renfoncement de la carte de montage d'élément photosemi-conducteur et

une section de résine de scellage dans laquelle le renfoncement est rempli pour sceller l'élément photosemi-conducteur,

dans lequel au moins des parties des faces de paroi du renfoncement sont faites d'une composition de résine thermodurcissable durcie selon l'une quelconque des revendications 3 à 9.

Fig.1

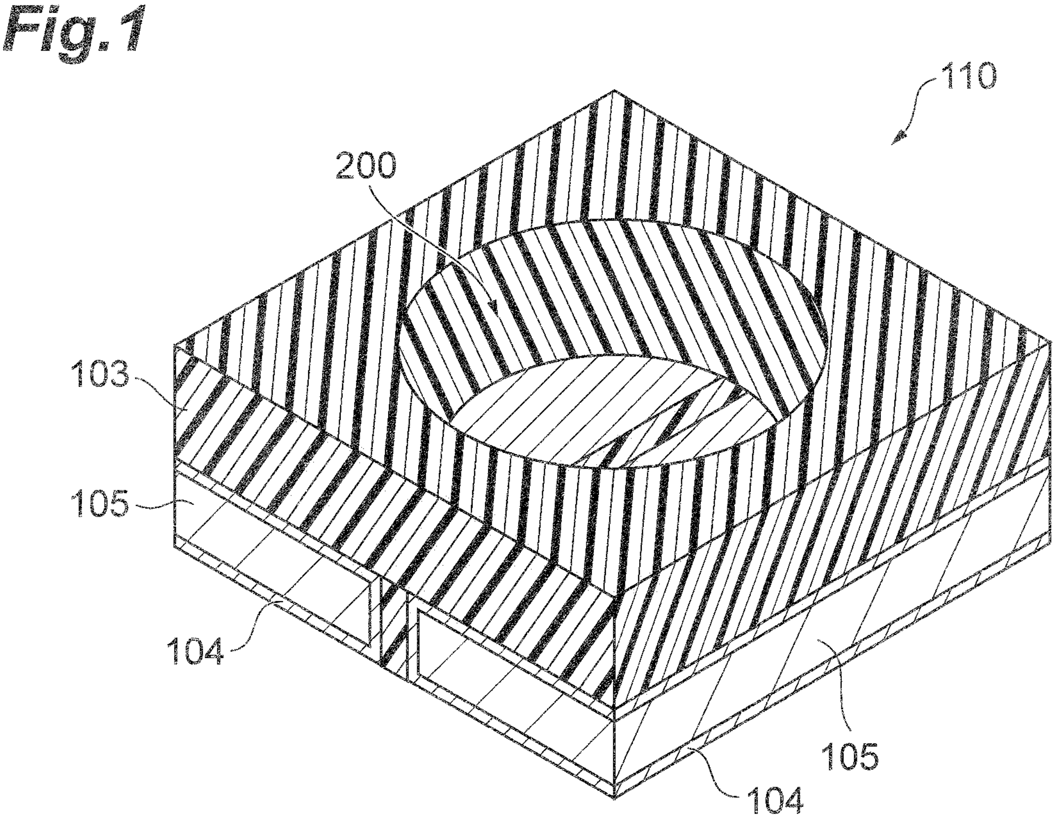

Fig.2

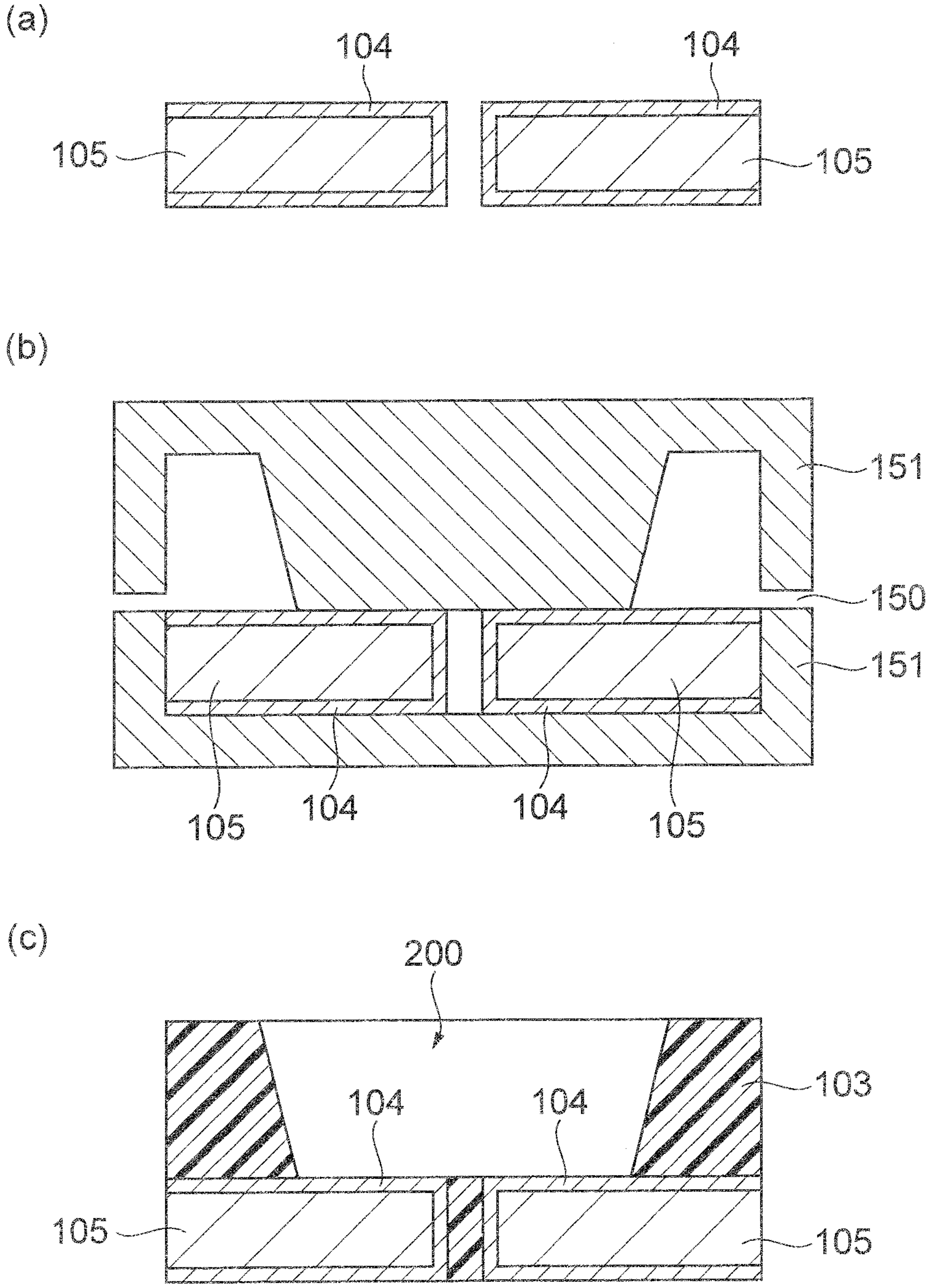
(a)
104
104
105
105
(b)
151
150
151
105
104
104
105
(c)
200
104
104
103
105
105

Fig.3

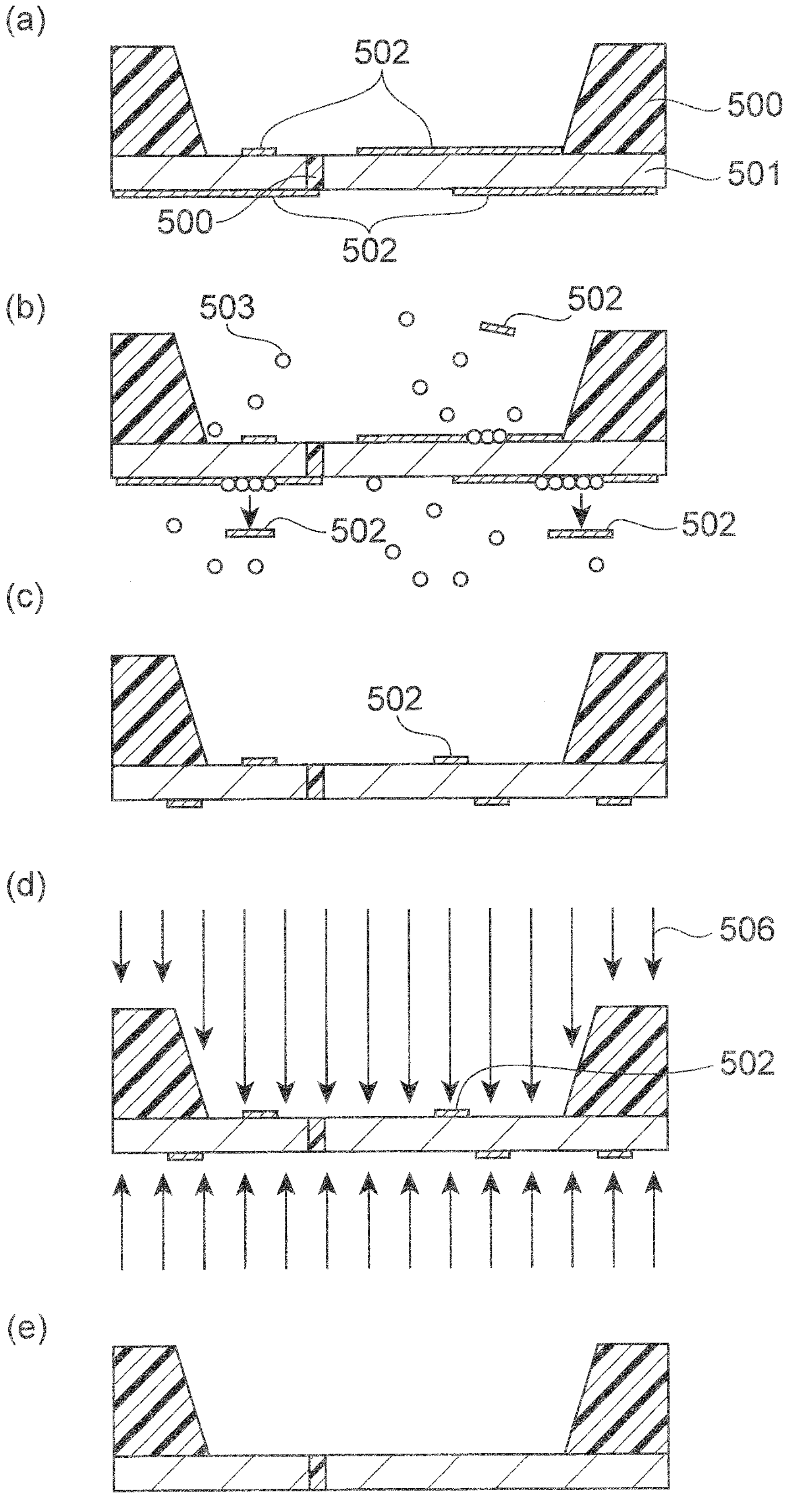

*Fig.4*

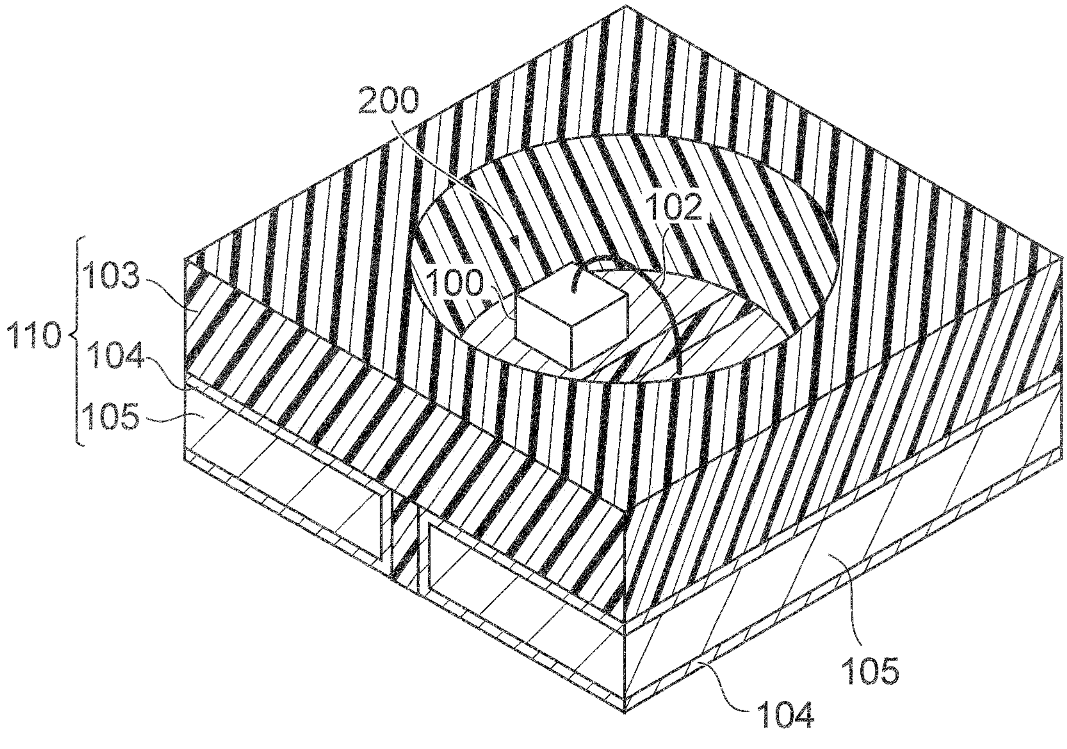

Fig.5

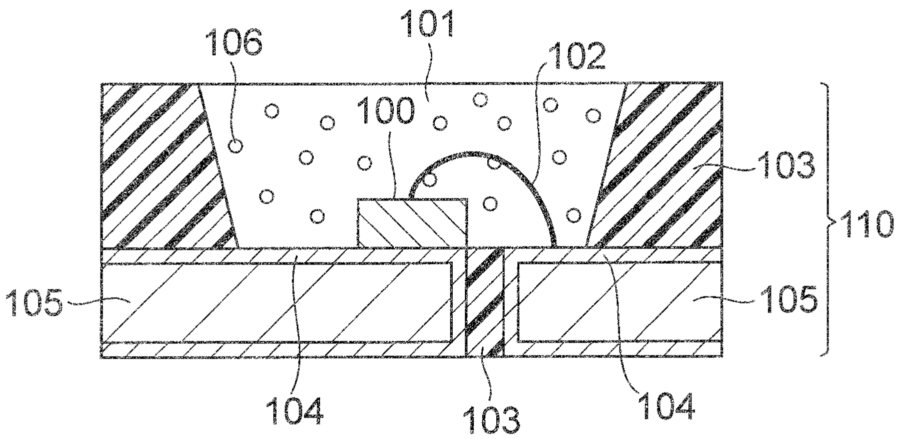

Fig.6

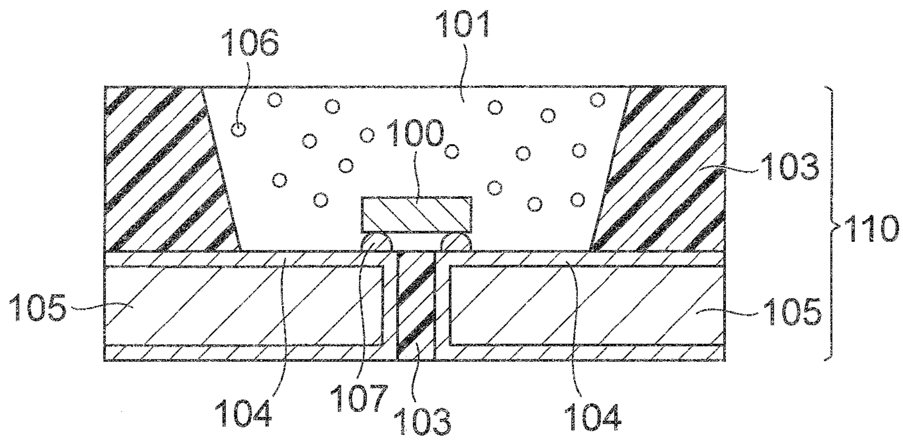

Fig.7

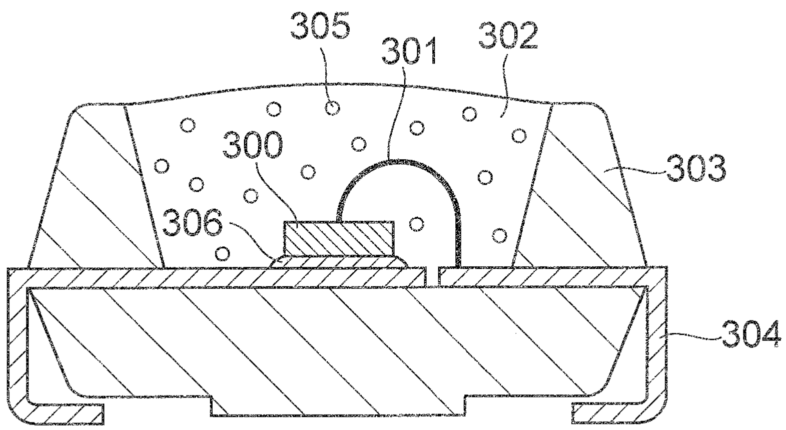

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006140207 A
- WO 2009088059 A